# EUROPEAN PATENT APPLICATION

(11) **EP 4 509 858 A1**
(43) Date of publication of application: **19.02.2025**
(21) Application number: 24188354.5
(22) Date of filing: 12.07.2024
(51) Int. Cl.: G01R 33/00

(54) **TEMPERATURE REGULATION OF INTEGRATED CIRCUIT ELEMENTS**

(30) Priority: 14.08.2023 US 202318449219
(71) Applicant: Allegro MicroSystems, LLC, Manchester, NH 03103 (US)
(72) Inventor: Fahmy, Ahmed Hassan, Andover, 01810 (US); Cadugan, Bryan, Bedford, 03110 (US)
(74) Representative: South, Nicholas Geoffrey

(57) **Abstract**

A semiconductor package, comprising: a substrate; an analog circuitry that is formed on the substrate; a first heating element that is formed on the substrate; a first temperature sensing element that is formed on the substrate; a first heating control circuitry that is formed on the substrate, the first heating control circuitry being configured to detect whether a first temperature measurement that is taken with the first temperature sensing element is below a first threshold, and turn on the first heating element in response to detecting that the first temperature measurement is below the first threshold, the first heating element being turned on only when the first temperature measurement is below the first threshold; and an encapsulating material configured to encapsulate the substrate, the analog circuitry, the first temperature sensing element, the first heating element, and the first heating control circuitry.

## Description

### BACKGROUND

Low temperatures can impact the performance of electronic circuits in several ways. One prominent effect is the increase in the resistance of conductive materials. This elevated resistance can lead to voltage drops and signal attenuation, causing deviations from expected circuit behavior and potential signal loss. Additionally, low temperatures can result in slower response times, reduced sensitivity, and increased error rates.

### SUMMARY

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

According to aspects of the disclosure, a sensor package is provided comprising: a substrate; a sensing element that is formed on the substrate; a digital processing circuitry that is formed on the substrate, the digital processing circuitry being configured to generate an output signal based on a signal that is generated at least by the sensing element; a temperature sensing element that is configured to measure a temperature inside the sensor package; one or more heating elements that are configured to heat at least the sensing element; a heating control circuitry that is configured to: receive a temperature measurement that is at least in part generated by the temperature sensing element, detect whether the temperature measurement is below a first threshold, and turn on the one or more heating elements when the temperature measurement is below the first threshold, the one or more heating elements being turned on only when the temperature measurement is below the first threshold; and an encapsulating material that is configured to encapsulate the substrate, the temperature sensing element, the digital processing circuitry, the one or more heating elements, and the heating control circuitry.

In an embodiment, the one or more heating elements are provided in the sensor package exclusively for generating heat.

In an embodiment, any of the heating elements includes one or more resistors.

In an embodiment, at least one of the heating elements includes a first portion and a second portion, the first portion being configured to generate a first magnetic field and the second portion being configured to generate a second magnetic field that at least partially cancels the first magnetic field.

In an embodiment, the one or more heating elements include a conductive trace.

In an embodiment, the one or more heating elements include a conductive trace that is arranged to define a loop that at least partially surrounds the one or more heating elements.

In an embodiment, the sensing element includes one or more of a magnetic field sensing element, an optical sensing element, or an acoustic sensing element.

In an embodiment, the sensor package further includes an analog circuitry that is formed on the substrate, the analog circuitry being configured to process the signal that is generated by the sensing element, the one or more heating elements being further configured to heat the analog circuitry.

According to aspects of the disclosure, a semiconductor package is provided, comprising: a substrate; an analog circuitry that is formed on the substrate; a first heating element that is formed on the substrate; a first temperature sensing element that is formed on the substrate; a first heating control circuitry that is formed on the substrate, the first heating control circuitry being configured to detect whether a first temperature measurement that is taken with the first temperature sensing element is below a first threshold, and turn on the first heating element in response to detecting that the first temperature measurement is below the first threshold, the first heating element being turned on only when the first temperature measurement is below the first threshold; and an encapsulating material configured to encapsulate the substrate, the analog circuitry, the first temperature sensing element, the first heating element, and the first heating control circuitry.

In an embodiment, the first heating control circuitry includes a digital control circuit and a digital-to-analog converter (DAC), the digital control circuit is configured to select a heating level for the first heating element, generate a digital signal specifying the heating level, and provide the digital signal to the DAC, and the DAC is configured to generate an analog signal based on the digital signal and power the first heating element with the analog signal.

In an embodiment, the first heating control circuitry is further configured to detect whether the first temperature measurement is above a second threshold and turn off the first heating element in response to detecting that the first temperature measurement is above the second threshold.

In an embodiment, the first heating element includes a resistor.

In an embodiment, the first heating element includes a conductive trace.

In an embodiment, the first heating element includes a conductive trace that is arranged to define a loop that runs on a periphery of the substrate.

In an embodiment, the first heating element includes a conductive trace that is arranged to surround the analog circuitry.

In an embodiment, the semiconductor package further comprises a second heating element, wherein the first heating control circuitry is further configured to turn on the second heating element in response to the first temperature measurement being below the first threshold.

In an embodiment, the first heating element and the second heating element are disposed on opposite sides of the analog circuitry.

In an embodiment, the semiconductor package further comprises a second heating element, a second heating control circuitry, and a second temperature sensing element, wherein the second heating control circuitry is configured to detect whether a second temperature measurement that is taken with the second temperature sensing element is below the first threshold and turn on the second heating element in response to detecting that the second temperature measurement is below the first threshold.

In an embodiment, the first heating element and the second heating element are disposed on opposite sides of the analog circuitry, and the first and second temperature sensing elements are disposed on opposite sides of the analog circuitry.

In an embodiment, the semiconductor package further comprises a second heating element, wherein the first heating element includes a conductive trace that is arranged to at least partially surround a first portion of the analog circuitry and the second heating element includes a second conductive that is arranged to at least partially surround a second portion of the analog circuitry.

In an embodiment, the analog circuitry includes one or more amplifiers and one or more analog-to-digital converters.

In an embodiment, the semiconductor package further comprises one or more sensing elements.

In an embodiment, the first heating element includes a first portion and a second portion, the first portion being configured to generate a first magnetic field and the second portion being configured to generate a second magnetic field that at least partially cancels the first magnetic field.

According to aspects of the disclosure, a method is provided for use in a semiconductor package, comprising: receiving a temperature measurement that is taken by a temperature sensing element disposed inside the semiconductor package; detecting whether the temperature measurement is below a first threshold; in response to detecting that the temperature measurement is below the first threshold, turning on a heating element that is disposed inside the semiconductor package, the heating element being turned on only when the temperature measurement is below the first threshold, wherein the heating element is formed on a same substrate as a sensing element, the heating element is configured to heat the sensing element, and the heating element and the sensing element are encapsulated inside an encapsulating material that is used to form the semiconductor package.

In an embodiment, the sensing element includes a magnetic field sensing element.

In an embodiment, the method further comprises detecting whether the temperature measurement is above a second threshold while the heating element is turned on; and turning off the heating element when the temperature measurement is above the second threshold while the heating element is turned on.

According to aspects of the disclosure, a semiconductor package is provided, comprising: means for taking a temperature measurement inside the semiconductor package; means for detecting whether the temperature measurement is below a first threshold; means for turning on a heating element that is disposed inside the semiconductor package in response to sensing that the temperature measurement is below the first threshold, the heating element being turned on only when the temperature measurement is below the first threshold, wherein the heating element is arranged to heat a sensing element is part of the semiconductor package.

### BRIEF DESCRIPTION OF THE DRAWING FIGURES

Other aspects, features, and advantages of the claimed invention will become more fully apparent from the following detailed description, the appended claims, and the accompanying drawings in which like reference numerals identify similar or identical elements. Reference numerals that are introduced in the specification in association with a drawing figure may be repeated in one or more subsequent figures without additional description in the specification in order to provide context for other features.
FIG. 1 is a diagram of an example of a sensor, according to aspects of the disclosure;
FIG. 2 is a flowchart of an example of a process, according to aspects of the disclosure;
FIG. 3 is a diagram of an example of a heating controller, according to aspects of the disclosure;
FIG. 4A is a diagram of an example of a heating controller, according to aspects of the disclosure;
FIG. 4B is a diagram of an example of a heating controller, according to aspects of the disclosure;
FIG. 5A is a diagram of an example of a heating element, according to aspects of the disclosure;
FIG. 5B is a diagram of an example of a heating element, according to aspects of the disclosure;
FIG. 5C is a diagram of an example of a heating element, according to aspects of the disclosure;
FIG. 5D is a diagram of an example of a heating element, according to aspects of the disclosure;
FIG. 6A is a diagram of an example of a sensor, according to aspects of the disclosure;
FIG. 6B is a diagram of an example of a sensor, according to aspects of the disclosure;
FIG. 6C is a diagram of an example of a sensor, according to aspects of the disclosure;
FIG. 6D is a diagram of an example of a sensor, according to aspects of the disclosure;
FIG. 6E is a diagram of an example of a sensor, according to aspects of the disclosure; and
FIG. 6F is a diagram of an example of a sensor, according to aspects of the disclosure.

### DETAILED DESCRIPTION

Many magnetic sensing technologies (like Hall-effect sensors, giant magnetoresistors (GMRs), and tunnel magnetoresistors (TMRs)) are sensitive to temperature. When building products with these temperature-sensitive sensing elements, significant effort has to be made in design and production to ensure the product meets the target accuracy across the predefined range of temperatures. The common temperature range used for commercial chips is from -40°C up to 85°C and sometimes more. To maintain the operation of the chip within such a wide range of temperatures, digital correction is usually applied. For the digital correction to work, an on-chip temperature sensor is needed to provide a digital value for the operating temperature. This value is given to the digital correction logic to perform correction for the sensor output based on the known behavior of the sensor across temperature. However, the temperature sensitivity of the sensing element is not always constant. It usually varies from chip to chip due to process variation. So, this temperature sensitivity (which varies from chip to chip) has to be characterized in the testing process of each individual sensor package. This characterization results in a correction factor that should be programmed in non-volatile memory. This correction factor, in turn, will be used by the digital correction logic to account for the sensitivity profile of each individual sensor package. In testing, this process usually requires measurements at three temperatures: room temperature, hot temperature, and cold temperature.

In one aspect of the disclosure, a sensor package is provided that includes a heating element formed around the sensing element(s) in the sensor package. The heat generated by the heating element may be controlled by a current digital-to-analog converter (DAC). The current DAC may be activated when the measured temperature is less than a predefined temperature (which could be room temperature). So, at a cold temperature, the heating element will be activated, thus raising the temperature of the sensing element until a target temperature is reached. Once the target temperature is reached, no further heating may be applied. By applying this idea, the operating temperature range of the sensor package may be halved (because the heating element inside the sensor package would prevent the temperature of the sensor package from falling all the way down to the lower bound of the temperature range).

In one aspect, preventing the temperature of a sensor package from dropping below a threshold value is advantageous because it allows highly sensitive magnetic sensors at cold temperatures to be used with better accuracy while reducing the testing and design costs required for calibration and trimming at low temperatures.

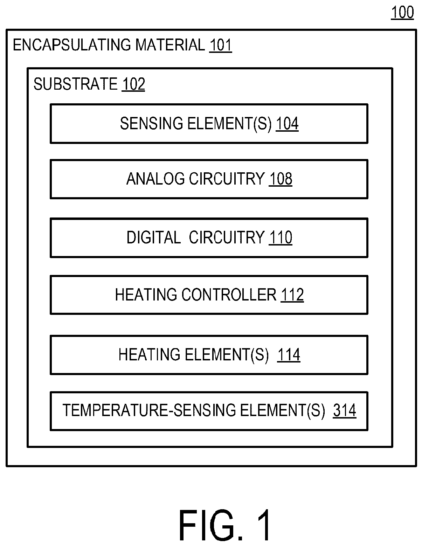

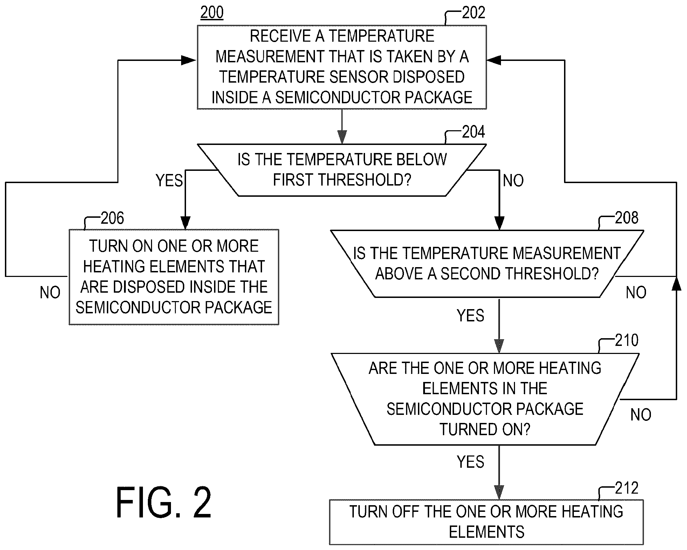

FIG. 1 is a diagram of an example of a sensor package 100, according to aspects of the disclosure. As illustrated, the sensor package 100 may include a substrate 102. Formed on the substrate 102 may be one or more sensing elements 104, analog circuitry 108, digital circuitry 110, a heating controller 112, a set of heating elements 114, and a set of temperature-sensing elements 314. In some implementations, the set of heating elements 114 may include one or more of a heating element 114A, a heating element 114B, a heating element 114C, and a heating element 114D, all of which are discussed further below with respect to FIGS. 2-6F. Each of the heating elements in the set 114 may include one or more of a resistor, a heating coil, a conductive trace, and/or any other suitable type of device configured to generate heat. In some implementations, the set of temperature-sensing elements 314 may include one or more of a temperature-sensing element 314A, a temperature-sensing element 314B, a temperature-sensing element 314C, and a temperature-sensing element 314D, all of which are discussed further below with respect to FIGS. 2-6F. Each of the temperature-sensing elements in set 314 may include a thermistor, a resistance temperature detector, and/or any other suitable type of device arranged to measure temperature.

The substrate 102, sensing elements 104, analog circuitry 108, digital circuitry 110, heating controller 112, set of heating elements 114, and set of temperature-sensing elements 314 may be encapsulated in an encapsulating material 101. The encapsulating material 101 may include epoxy and/or any other suitable type of encapsulant.

In some implementations, each of the sensing elements 104 may include one or more magnetic field sensing elements. Each magnetic field sensing element can be, but is not limited to, a Hall Effect element, a magnetoresistance element, a magnetotransistor, or an inductive coil. As is known, there are different types of Hall Effect elements, for example, a planar Hall element, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or a full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium Arsenide (GaAs) or an Indium compound, e.g., Indium Antimonide (InSb).

The analog circuitry 108 may include one or more amplifiers, one or more analog-to-digital converters (ADCs), one or more digital-to-analog converters (DACs), and/or any other suitable type of analog circuitry. The digital circuitry 110 may include one or more of a general-purpose processor, a special-purpose processor, a field-programmable gate array, a signal processor, and/or any other suitable type of processing circuitry. In some implementations, the digital circuitry 110 may receive a signal that is generated, at least in part, by the sensing elements 104 and produce an output signal in response. For instance, when the sensing elements 104 are magnetic field sensing elements, the input signal may indicate magnetic flux density, and the output signal may indicate the speed of a target, the position of a target, or the level of electrical current through a wire, for example.

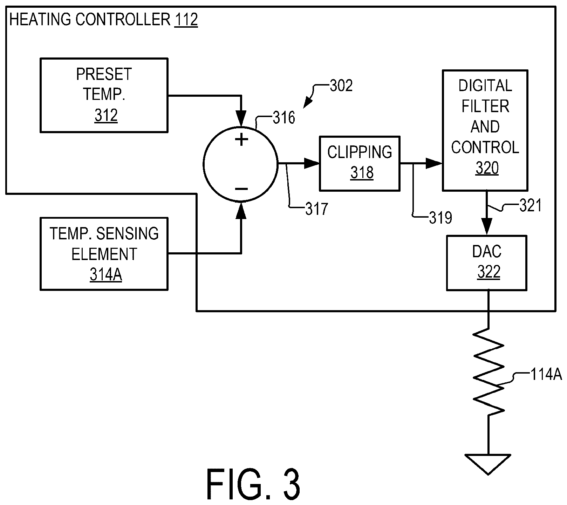

The heating controller 112 may include any suitable type of electronic circuitry that is configured to turn on and off the heating elements 114. In some implementations, the heating controller 112 may include any suitable type of electronic circuitry that is configured to perform a process 200, which is discussed further below with respect to FIG. 2. Additionally or alternatively, in some implementations, the heating controller 112 may be configured as discussed further below with respect to FIG. 3. It will be understood that the present disclosure is not limited to any specific implementation of the heating controller 112.

FIG. 2 is a flowchart of an example of a process 200 for controlling one or more heating elements in set 114 (hereinafter "respective heating element(s)"), according to aspects of the disclosure. According to the present example, process 200 is performed by the heating controller 112. However, the present disclosure is not limited to any specific entity performing the process 200 or a portion thereof.

At step 202, the heating controller 112 receives a temperature measurement. According to the present example, the temperature measurement is generated, at least in part, by one of the temperature-sensing elements in the set 314.

At step 204, the heating controller 112 detects whether the temperature measurement is below a first threshold. According to the present example, the first threshold is equal to -20C. However, the present disclosure is not limited to any specific value for the first threshold. If the temperature measurement is below the first threshold, process 200 proceeds to step 208. Otherwise, process 200 proceeds to step 206.

At step 206, the heating controller 112 turns on the heating elements in set 114, after which the process 200 returns to step 202.

At step 208, the heating controller 112, determines whether the temperature measurement is above a second threshold. According to the present example, the second threshold is equal to 25C (or room temperature). However, the present disclosure is not limited to any specific value for the second threshold. If the temperature measurement is above the second threshold, process 200 proceeds to step 210. Otherwise, process 200 returns to step 202.

At step 210, the heating controller 112, detects whether any of the heating elements in set 314 are turned on. If any of the heating elements in set 114 are turned on, process 200 proceeds to step 212. Otherwise, process 200 returns to step 202.

At step 212, the heating controller 112 turns off the heating elements that were determined to be turned on at step 210.

FIG. 3 is a diagram of the heating controller 112, in accordance with one possible implementation. In the example of FIG. 3, the heating controller 112 is configured to turn on at least one of the heating elements in set 114 whenever the temperature of the sensor package 100 falls below a threshold (i.e., the threshold stored in a register 312), effectively shifting up the lower bound of the operating temperature of the sensor package 100 by preventing the temperature of the sensor package 100 from falling, or remaining for extended periods of time, below the threshold.

According to the example of FIG. 3, the heating controller 112 includes a signal path 302. The signal path 302 may include the register 312, a subtraction circuit 316, a clipping circuit 318, a digital filter and control circuit 320 (hereinafter referred to as "circuit 320"), and a current digital-to-analog converter (DAC) 322. Register 312 may be configured to store the value of a threshold. According to the present example, the threshold is equal to -20°C. However, the present disclosure is not limited to any specific value for the threshold. The subtraction circuit 316 may be configured to subtract, from the value of the threshold, a temperature measurement that is taken by a temperature-sensing element 314A, and output a signal 317 that is indicative of the difference. The clipping circuit 318 may be configured to receive signal 317 as input and output a signal 319 that is based on signal 317. Specifically, if the value of signal 317 is less than zero, the clipping circuit 318 may set the value of signal 319 to zero (e.g., by setting every bit in signal 319 to '0'). Otherwise, if the value of signal 317 is greater than zero, the clipping circuit 318 may cause signal 319 to have the same value as signal 317. Circuit 320 may receive signal 319 as input and generate a signal 321 based on signal 319. DAC 322 may receive the signal 321, convert it to an analog signal and use the analog signal to drive a heating element 114A.

In one implementation, circuit 320 may be configured to map the value of signal 319 to a corresponding value for signal 321. For instance, if the value of signal 319 is zero, circuit 320 may set the value of signal 321 to zero as well, thus turning off the heating element 114A, or maintaining it in a turned-off state. Alternatively, if the value of signal 319 is greater than zero, circuit 320 may set signal 321 to a value that would cause the DAC 322 to start supplying (or continue supplying) electrical current to heating element 114A. For instance, circuit 320 may set signal 321 to a first value that would cause DAC 322 to supply 0.12A of electrical current to heating element 114A. In other words, if the value of signal 319 is greater than zero, the circuit 320 may turn on the heating element 114A or maintain the heating element 114A in a turned-on state.

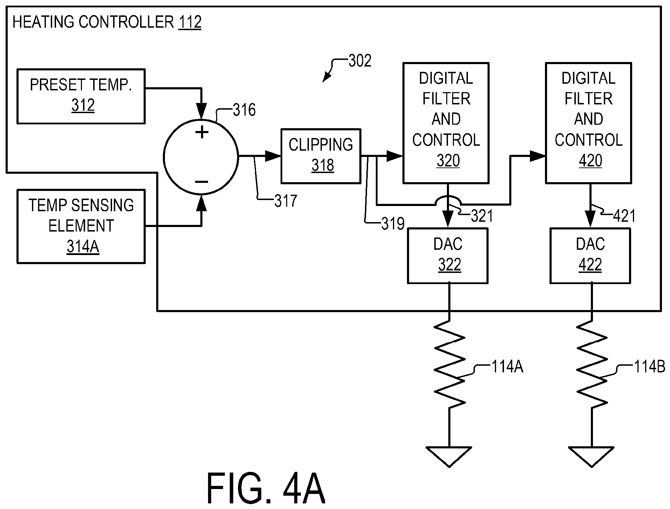

FIG. 4A is a diagram of the heating controller 112, in accordance with another implementation. The implementation of the heating controller 112, which is shown in FIG. 4A, is nearly identical to the implementation shown in FIG. 3, except for the signal path 302 further including a digital filter and control circuit 420 (hereinafter referred to as "circuit 420"), a current DAC 422 that is arranged to drive a heating element 114B. The circuit 420 may be configured to receive signal 319 from clipping circuit 318, generate a signal 421 based on signal 319, and provide signal 421 to DAC 422. DAC 422 may convert signal 421 to an analog signal and use the analog signal to drive the heating element 114B.

In one implementation, circuits 320 and 420 may be arranged to provide different levels of electrical current to heating elements 114A and 114B, respectively, so as to cause heating elements 114A and 114B to generate different amounts of heat. For instance, when the value of signal 319 is greater than zero, circuit 320 may be arranged to cause DAC 322 to supply 1.2A of electrical current to heating element 114A and circuit 420 may be arranged to cause DAC 422 to supply 1.4A of electrical current to heating element 114B. Alternatively, in some implementations, circuits 320 and circuit 420 may have identical configurations, and they may be arranged to provide the same level of electrical current to heating elements 114A and 114B, respectively.

In some implementations, circuits 320 and 420 may be configured to implement the same algorithm (or transfer function) for mapping the value of an input signal to the respective value of an output signal. In such implementations, signals 421 and 321 may have the same value. Alternatively, in some implementations, circuit 320 and 420 may be configured to implement different algorithms (or transfer functions) for mapping the value of an input signal to the respective value of an output signal. In such implementations, signals 421 and 321 may have different values. As can be readily appreciated, this may allow different zones of substrate 101 (and/or the sensor package 100) to be heated differently to achieve a more precise temperature profile of substrate 101 and/or sensor package 100.

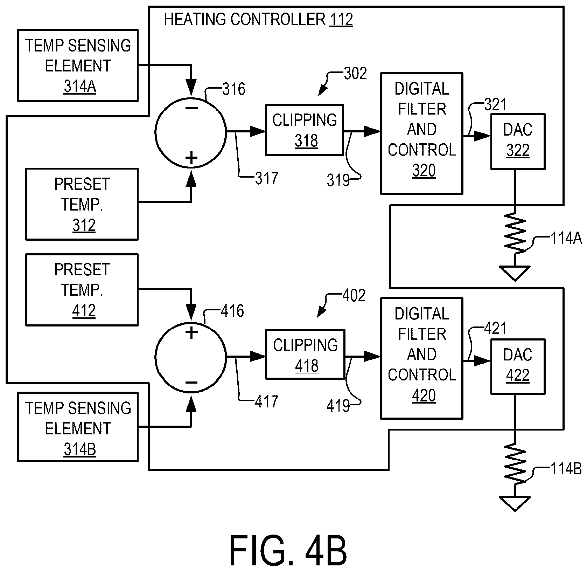

FIG. 4B is a diagram of the heating controller 112, in accordance with yet another implementation. The implementation of the heating controller 112, which is shown in FIG. 4B, is nearly identical to the implementation shown in FIG. 4A, except for including a second signal path 402, and the circuit 420 and DAC 422 being part of the signal path 402.

The signal path 402 may include a memory register 412, a temperature-sensing element 314B, a subtraction circuit 416, a clipping circuit 418, the digital filter and control circuit 420, and the DAC 422. Register 412 may be configured to store the value of a threshold. According to the present example, the threshold is equal to -20°C. However, the present disclosure is not limited to any specific value for the threshold in register 412. The subtraction circuit 416 may be configured to subtract, from the value of the threshold, a temperature measurement that is taken by a temperature sensing element 314B, and output a signal 417 that is indicative of the difference. The clipping circuit 418 may be configured to receive signal 417 as input and output a signal 419 that is based on signal 417. Specifically, if the value of signal 417 is less than zero, the clipping circuit 418 may set the value of signal 419 to zero (e.g., by setting every bit in signal 419 to '0'). Otherwise, if the value of signal 417 is greater than zero, the clipping circuit 418 may cause signal 419 to have the same value as signal 417. Circuit 420 may receive signal 419 as input and generate a signal 421 based on signal 419. DAC 422 may receive the signal 421, convert it to an analog signal and use the analog signal to drive a heating element 114B.

In some implementations, circuits 320 and 420 may be configured to implement the same algorithm (or transfer function) for mapping the value of an input signal to the respective value of an output signal. In such implementations, signals 421 and 321 may have the same value if signals 319 and 419 have the same value. Alternatively, in some implementations, circuits 320 and 420 may be configured to implement different algorithms (or transfer functions) for mapping the value of an input signal to the respective value of an output signal. In such implementations, signals 421 and 321 may have different values when signals 319 and 419 have the same value. As can be readily appreciated, this may allow different zones of substrate 101 (and/or the sensor package 100) to be heated differently to achieve a more precise temperature profile of substrate 101 and/or sensor package 100.

According to the example of FIG. 4, registers 312 and 412 store the same threshold value. However, alternative implementations are possible in which registers 312 and 412 store different threshold values. Stated succinctly, the present disclosure is not limited to any specific implementation of registers 312 and 412.

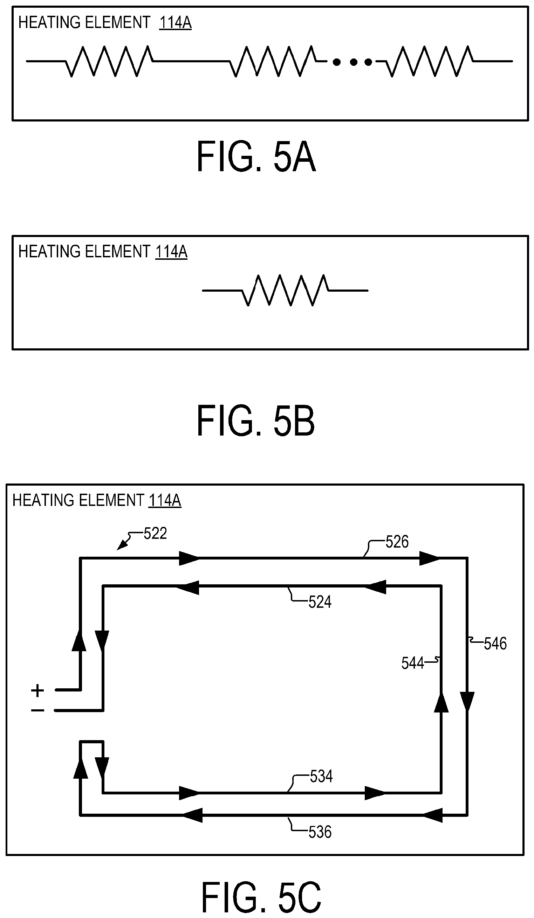

FIG. 5A is a diagram of the heating element 114A, according to aspects of the disclosure. FIG. 5A illustrates that, in some implementations, the heating element 114A may include a plurality of resistors that are coupled to one another in series. FIG. 5B is a diagram of the heating element 114A, according to aspects of the disclosure. FIG. 5B illustrates that, in some implementations, the heating element 114A may include only one resistor.

FIG. 5C is a diagram of the heating element 114A, in accordance with yet another implementation. FIG. 5C illustrates that in some implementations, the heating element 114A may be implemented by using a conductive trace 522 that is arranged to define a loop. The conductive trace may be formed on substrate 102 (shown in FIG. 1). The conductive trace may include portions 524, 534, 544, 526, 536, and 546. In some implementations, the conductive trace 522 may be configured so that when energized, electrical current flows through portions 524, 434, and 544 in a first direction and through portions 526, 536, and 546 in a second direction that is opposite to the first direction. This arrangement is advantageous because it reduces the magnetic inductance of the heating element 114A, as any magnetic fields originating from portions 524, 534, and 544 would be canceled (at least partially) by the magnetic field originating from portions 526, 536, and 546. The cancellation is in turn advantageous because it decreases (or ideally eliminates) the degree to which the heating element 114A would interfere with the operation of magnetic field sensing elements that are formed on the same substrate as the heating element 114A and/or in the same semiconductor package.

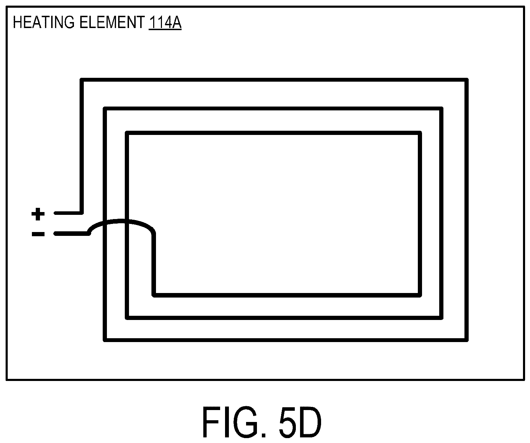

FIG. 5D is a diagram of the heating element 114A, in accordance with yet another implementation. In the example of FIG. 5D, the heating element 114A includes a coil that is formed using a conductive trace. The conductive trace may be formed on substrate 102.

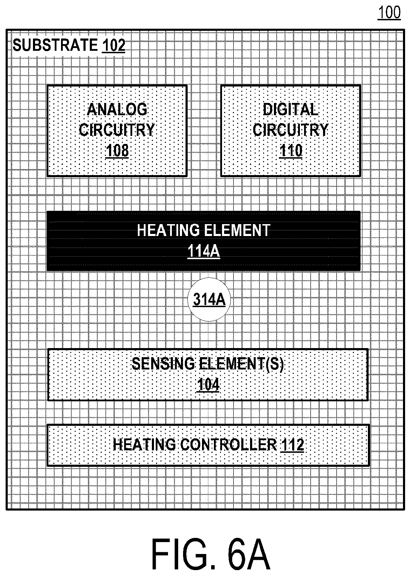

FIG. 6A is a schematic diagram of the sensor package 100, showing one possible physical layout of the sensor package 100 when configured as discussed above with respect to FIG. 3. As illustrated, in the example of FIG. 6A, the heating element 114A may be formed in a central portion of the substrate between the analog circuitry 108, the digital circuitry 110, and the sensing elements 104.

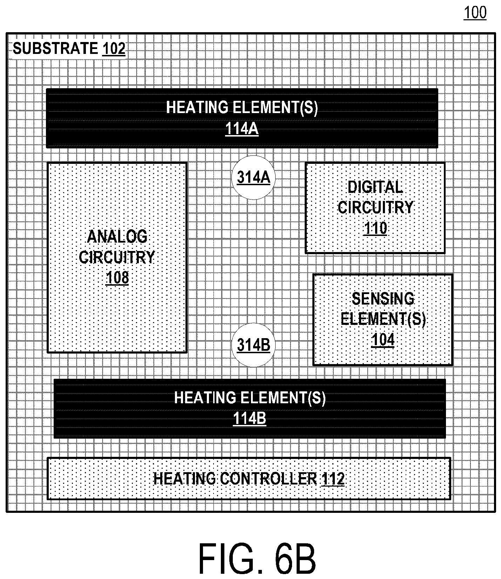

FIG. 6B is a schematic diagram of the sensor package 100, showing one possible physical layout of the sensor package 100 when configured as discussed above with respect to FIGS. 4A-B. As illustrated, in the example of FIG. 6B, the heating elements 114A and 114B may be formed on opposite sides of the analog circuitry 108, the digital circuitry 110, and the sensing elements 104.

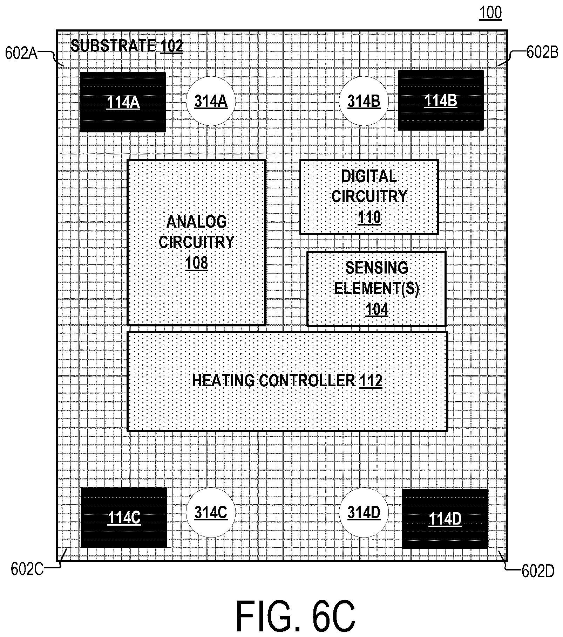

FIG. 6C is a schematic diagram of the sensor package 100, showing the physical layout of the sensor package 100 in accordance with yet another implementation. In the example of FIG. 6C, the sensor package is equipped with heating elements 114A, 114B, 114C, and 114D. As illustrated, each of the heating elements 114A, 114B, 114C, and 114D may be formed in a different corner of the substrate 102. Each of the heating elements 114A, 114B, 114C, and 114D may be controlled by the heating controller 112 based on the output of a different temperature-sensing element. For example, heating element 114A may be controlled based on the output of temperature-sensing element 314A, heating element 114B may be controlled based on the output of temperature-sensing element 314B, heating element 114C may be controlled based on the output of temperature-sensing element 314C, and heating element 114D may be controlled based on the output of temperature-sensing element 314D. Heating element 114A and temperature-sensing element 314A may be formed adjacent to corner 602A of substrate 102; heating element 114B and temperature-sensing element 314B may be formed adjacent to corner 602B of substrate 102; heating element 114C and temperature-sensing element 314C may be formed adjacent to corner 602C of substrate 102; and heating element 114D and temperature-sensing element 314D may be formed adjacent to corner 602D of substrate 102.

According to the present example, each of the heating elements 114A, 114B, 114C, and 114D is controlled by a different digital filter and control circuit (not shown) that is part of the heating controller 112. However, alternative implementations are possible in which at least two of the heating elements 114A, 114B, 114C, and 114D are controlled by the same digital filter and control circuit. In such instances, heating elements that are controlled by the same digital filter and control circuit may be controlled based on the output of the same temperature-sensing element. In summary, the present disclosure is not limited to any specific method for controlling the heating elements 114A, 114B, 114C, and 114D.

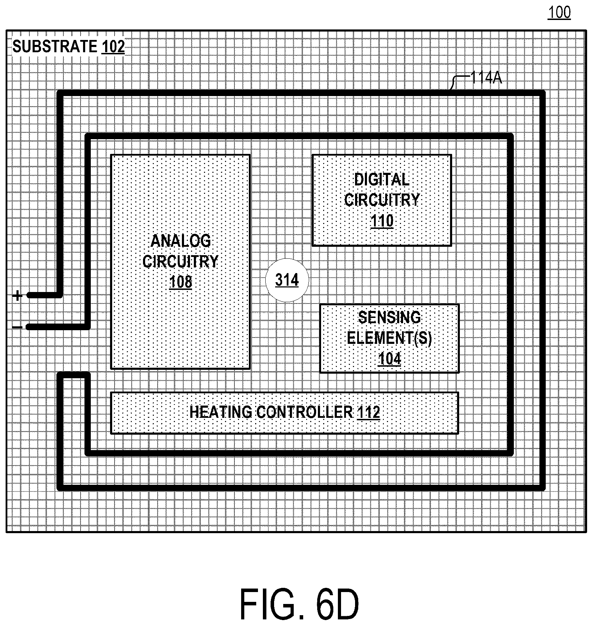

FIG. 6D is a schematic diagram of the sensor package 100, showing one possible physical layout of the sensor package 100 when the sensor package 100 is configured in the manner discussed above with respect to FIG. 3. In the example of FIG. 6D, the heating element may be arranged in the manner discussed above with respect to FIG. 5C. Specifically, the heating element 114A may be formed of a conductive trace that is arranged to define a loop running along the periphery of substrate 102. As illustrated, the conductive trace may be arranged to at least partially surround the analog circuitry 108, the digital circuitry 110, the sensing elements 104, and the heating controller 112.

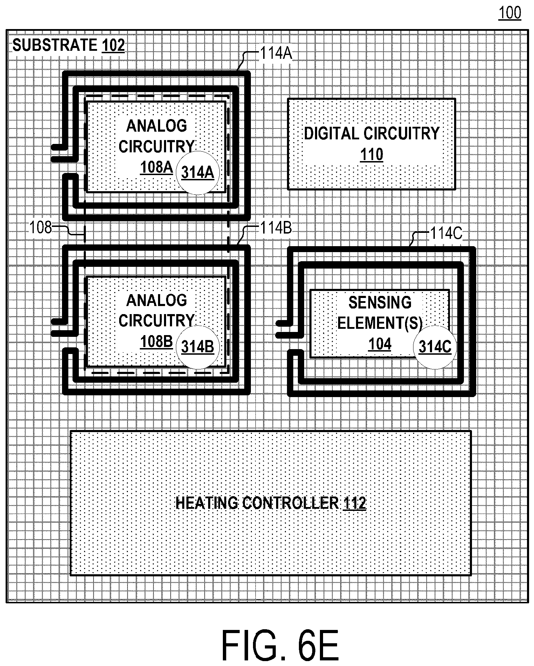

FIG. 6E is a schematic diagram of the sensor package 100, showing the physical layout of the sensor package 100, in accordance with yet another implementation. In the example of FIG. 6E, the sensor package is provided with heating elements 114A, 114B, and 114C. As illustrated, each of the heating elements 114A, 114B, and 114C may be arranged in the manner discussed above with respect to FIG. 5C. Heating element 114A may include a conductive trace forming a loop that at least partially surrounds a portion 108A (e.g., an amplifier) of analog circuitry 108. Heating element 114B may include a conductive trace forming a loop that at least partially surrounds a portion 108B (e.g., an analog-to-digital converter) of the analog circuitry 108. Heating element 114C may include a conductive trace that forms a loop surrounding the sensing elements 104.

Each of the heating elements 114A, 114B, and 114C may be controlled by the heating controller 112 based on the output of a different temperature-sensing element. For example, heating element 114A may be generated based on the output of a temperature-sensing element 314A, heating element 114B may be controlled based on the output of a temperature-sensing element 314B, and heating element 114C may be controlled based on the output of a temperature-sensing element 314C. Although, in the example of FIG. 6E, the temperature-sensing element 314A is positioned inside the loop defined by heating element 114A, the present disclosure is not limited to any specific position of the temperature-sensing element. Although, in the example of FIG. 6E, the temperature-sensing element 314B is positioned inside the loop defined by heating element 114B, the present disclosure is not limited to any specific position of the temperature-sensing element. Although, in the example of FIG. 6E, the temperature-sensing element 314C is positioned inside the loop defined by heating element 114C, the present disclosure is not limited to any specific position of the temperature-sensing element.

According to the present example, each of heating elements 114A, 114B, and 114C is controlled by a different digital filter and control circuit (not shown). However, alternative implementations are possible in which at least two of the heating elements 114A, 114B, and 114C are controlled by the same digital filter and control circuit. In such instances, heating elements that are controlled by the same digital filter and control circuit may be controlled based on the output of the same temperature-sensing element. Stated succinctly, the present disclosure is not limited to any specific method for controlling the heating elements 114A, 114B, and 114C.

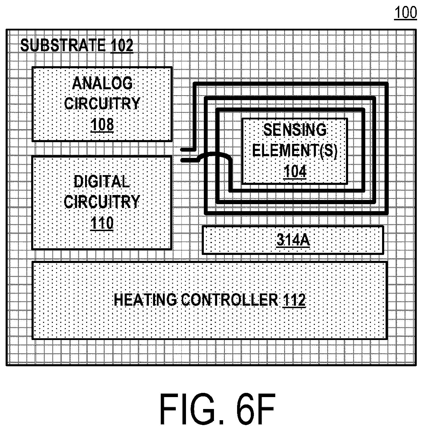

FIG. 6F is a schematic diagram of the sensor package 100, showing one possible physical layout of the sensor package 100 when configured as discussed above with respect to FIG. 3. As illustrated in the example of FIG. 6F, the heating element 114A may be formed by using a conductive trace that is arranged to define a loop, which at least partially surrounds the sensing elements 104.

FIGS. 1-6F are provided as an example only. Although the semiconductor package discussed with respect to FIGS. 1-6F is a sensor package, it will be understood that the concepts and ideas presented throughout the disclosure can be applied to any semiconductor package, rather than sensors only. Although in the example of FIG. 1-6F the sensor package 100 is a magnetic field sensor (e.g., a current sensor, a position sensor, an angle sensor, a speed sensor, *etc.*)*,* the present disclosure is not limited to the sensor package 100 being any specific type of sensor. For example, alternative implementations are possible in which the sensor package 100 is an optical sensor, a pressure sensor, a temperature sensor, an oxygen sensor, and/or any other suitable type of sensor. In such implementations, the sensing elements 104 may include an optical sensing element, a pressure sensing element, and/or any other suitable type of sensing element.

As used in this application, the word "exemplary" is used herein to mean serving as an example, instance, or illustration. Any aspect or design described herein as "exemplary" is not necessarily to be construed as preferred or advantageous over other aspects or designs. Rather, use of the word exemplary is intended to present concepts in a concrete fashion.

Additionally, the term "or" is intended to mean an inclusive "or" rather than an exclusive "or". That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. In addition, the articles "a" and "an" as used in this application and the appended claims should generally be construed to mean "one or more" unless specified otherwise or clear from context to be directed to a singular form.

To the extent directional terms are used in the specification and claims (e.g., upper, lower, parallel, perpendicular, etc.), these terms are merely intended to assist in describing and claiming the invention and are not intended to limit the claims in any way. Such terms, do not require exactness (e.g., exact perpendicularity or exact parallelism, etc.), but instead it is intended that normal tolerances and ranges apply. Similarly, unless explicitly stated otherwise, each numerical value and range should be interpreted as being approximate as if the word "about", "substantially" or "approximately" preceded the value of the value or range.

Moreover, the terms "system," "component," "module," "interface,", "model" or the like are generally intended to refer to a computer-related entity, either hardware, a combination of hardware and software, software, or software in execution. For example, a component may be, but is not limited to being, a process running on a processor, a processor, an object, an executable, a thread of execution, a program, and/or a computer. By way of illustration, both an application running on a controller and the controller can be a component. One or more components may reside within a process and/or thread of execution and a component may be localized on one computer and/or distributed between two or more computers.

Although the subject matter described herein may be described in the context of illustrative implementations to process one or more computing application features/operations for a computing application having user-interactive components the subject matter is not limited to these particular embodiments. Rather, the techniques described herein can be applied to any suitable type of user-interactive component execution management methods, systems, platforms, and/or apparatus.

While the exemplary embodiments have been described with respect to processes of circuits, including possible implementation as a single integrated circuit, a multi-chip module, a single card, or a multi-card circuit pack, the described embodiments are not so limited. As would be apparent to one skilled in the art, various functions of circuit elements may also be implemented as processing blocks in a software program. Such software may be employed in, for example, a digital signal processor, micro-controller, or general-purpose computer.

Some embodiments might be implemented in the form of methods and apparatuses for practicing those methods. Described embodiments might also be implemented in the form of program code embodied in tangible media, such as magnetic recording media, optical recording media, solid state memory, floppy diskettes, CD-ROMs, hard drives, or any other machine-readable storage medium, wherein, when the program code is loaded into and executed by a machine, such as a computer, the machine becomes an apparatus for practicing the claimed invention. Described embodiments might also be implemented in the form of program code, for example, whether stored in a storage medium, loaded into and/or executed by a machine, or transmitted over some transmission medium or carrier, such as over electrical wiring or cabling, through fiber optics, or via electromagnetic radiation, wherein, when the program code is loaded into and executed by a machine, such as a computer, the machine becomes an apparatus for practicing the claimed invention. When implemented on a general-purpose processor, the program code segments combine with the processor to provide a unique device that operates analogously to specific logic circuits. Described embodiments might also be implemented in the form of a bitstream or other sequence of signal values electrically or optically transmitted through a medium, stored magnetic-field variations in a magnetic recording medium, etc., generated using a method and/or an apparatus of the claimed invention.

It should be understood that the steps of the exemplary methods set forth herein are not necessarily required to be performed in the order described, and the order of the steps of such methods should be understood to be merely exemplary. Likewise, additional steps may be included in such methods, and certain steps may be omitted or combined, in methods consistent with various embodiments.

Also, for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

As used herein in reference to an element and a standard, the term "compatible" means that the element communicates with other elements in a manner wholly or partially specified by the standard, and would be recognized by other elements as sufficiently capable of communicating with the other elements in the manner specified by the standard. The compatible element does not need to operate internally in a manner specified by the standard.

It will be further understood that various changes in the details, materials, and arrangements of the parts which have been described and illustrated in order to explain the nature of the claimed invention might be made by those skilled in the art without departing from the scope of the following claims.

## Claims

1. A sensor package comprising:
a substrate;
a sensing element that is formed on the substrate;
a digital processing circuitry that is formed on the substrate, the digital processing circuitry being configured to generate an output signal based on a signal that is generated at least by the sensing element;
a temperature sensing element that is configured to measure a temperature inside the sensor package;
one or more heating elements that are configured to heat at least the sensing element;
a heating control circuitry that is configured to: receive a temperature measurement that is at least in part generated by the temperature sensing element, detect whether the temperature measurement is below a first threshold, and turn on the one or more heating elements when the temperature measurement is below the first threshold, the one or more heating elements being turned on only when the temperature measurement is below the first threshold; and
an encapsulating material that is configured to encapsulate the substrate, the temperature sensing element, the digital processing circuitry, the one or more heating elements, and the heating control circuitry.

2. The sensor package of claim 1, wherein the one or more heating elements are provided in the sensor package exclusively for generating heat.

3. The sensor package of claim 1, wherein any of the heating elements includes one or more resistors.

4. The sensor package of claim 1, wherein at least one of the heating elements includes a first portion and a second portion, the first portion being configured to generate a first magnetic field and the second portion being configured to generate a second magnetic field that at least partially cancels the first magnetic field.

5. The sensor package of claim 1, wherein the one or more heating elements include a conductive trace.

6. The sensor package of claim 1, wherein the one or more heating elements include a conductive trace that is arranged to define a loop that at least partially surrounds the one or more heating elements.

7. The sensor package of claim 1, wherein the sensing element includes one or more of a magnetic field sensing element, an optical sensing element, or an acoustic sensing element.

8. The sensor package of claim 1, further comprising an analog circuitry that is formed on the substrate, the analog circuitry being configured to process the signal that is generated by the sensing element, the one or more heating elements being further configured to heat the analog circuitry.

9. A semiconductor package, comprising:
a substrate;
an analog circuitry that is formed on the substrate;
a first heating element that is formed on the substrate;
a first temperature sensing element that is formed on the substrate;
a first heating control circuitry that is formed on the substrate, the first heating control circuitry being configured to detect whether a first temperature measurement that is taken with the first temperature sensing element is below a first threshold, and turn on the first heating element in response to detecting that the first temperature measurement is below the first threshold, the first heating element being turned on only when the first temperature measurement is below the first threshold; and
an encapsulating material configured to encapsulate the substrate, the analog circuitry, the first temperature sensing element, the first heating element, and the first heating control circuitry.

10. The semiconductor package of claim 9, wherein:
the first heating control circuitry includes a digital control circuit and a digital-to-analog converter (DAC),
the digital control circuit is configured to select a heating level for the first heating element, generate a digital signal specifying the heating level, and provide the digital signal to the DAC, and
the DAC is configured to generate an analog signal based on the digital signal and power the first heating element with the analog signal.

11. The semiconductor package of claim 9, wherein the first heating control circuitry is further configured to detect whether the first temperature measurement is above a second threshold and turn off the first heating element in response to detecting that the first temperature measurement is above the second threshold.

12. The semiconductor package of claim 9, wherein the first heating element includes a resistor.

13. The semiconductor package of claim 9, wherein the first heating element includes a conductive trace.

14. The semiconductor package of claim 9, wherein the first heating element includes a conductive trace that is arranged to define a loop that runs on a periphery of the substrate.

15. The semiconductor package of claim 9, wherein the first heating element includes a conductive trace that is arranged to surround the analog circuitry.

16. The semiconductor package of claim 9, further comprising a second heating element, wherein the first heating control circuitry is further configured to turn on the second heating element in response to the first temperature measurement being below the first threshold.

17. The semiconductor package of claim 16, wherein the first heating element and the second heating element are disposed on opposite sides of the analog circuitry.

18. The semiconductor package of claim 9, further comprising a second heating element, a second heating control circuitry, and a second temperature sensing element, wherein the second heating control circuitry is configured to detect whether a second temperature measurement that is taken with the second temperature sensing element is below the first threshold and turn on the second heating element in response to detecting that the second temperature measurement is below the first threshold.

19. The semiconductor package of claim 18, wherein the first heating element and the second heating element are disposed on opposite sides of the analog circuitry, and the first and second temperature sensing elements are disposed on opposite sides of the analog circuitry.

20. The semiconductor package of claim 9, further comprising a second heating element, wherein the first heating element includes a conductive trace that is arranged to at least partially surround a first portion of the analog circuitry and the second heating element includes a second conductive that is arranged to at least partially surround a second portion of the analog circuitry.

21. The semiconductor package of claim 9, wherein the analog circuitry includes one or more amplifiers and one or more analog-to-digital converters.

22. The semiconductor package of claim 9, further comprising one or more sensing elements.

23. The semiconductor package of claim 9, wherein the first heating element includes a first portion and a second portion, the first portion being configured to generate a first magnetic field and the second portion being configured to generate a second magnetic field that at least partially cancels the first magnetic field.

24. A method for use in a semiconductor package, comprising:
receiving a temperature measurement that is taken by a temperature sensing element disposed inside the semiconductor package;
detecting whether the temperature measurement is below a first threshold;
in response to detecting that the temperature measurement is below the first threshold, turning on a heating element that is disposed inside the semiconductor package, the heating element being turned on only when the temperature measurement is below the first threshold,
wherein the heating element is formed on a same substrate as a sensing element, the heating element is configured to heat the sensing element, and the heating element and the sensing element are encapsulated inside an encapsulating material that is used to form the semiconductor package.

25. The method of claim 24, wherein the sensing element includes a magnetic field sensing element.

26. The method of claim 24, further comprising:
detecting whether the temperature measurement is above a second threshold while the heating element is turned on; and
turning off the heating element when the temperature measurement is above the second threshold while the heating element is turned on.

27. A semiconductor package, comprising:
means for taking a temperature measurement inside the semiconductor package;
means for detecting whether the temperature measurement is below a first threshold;
means for turning on a heating element that is disposed inside the semiconductor package in response to sensing that the temperature measurement is below the first threshold, the heating element being turned on only when the temperature measurement is below the first threshold,
wherein the heating element is arranged to heat a sensing element is part of the semiconductor package.
